# EUROPÄISCHE PATENTSCHRIFT

(11) **EP 0 292 607 B1**
(45) Veröffentlichungstag und Bekanntmachung des Hinweises auf die Patenterteilung: **20.01.1993**
(21) Anmeldenummer: 87115553.7
(22) Anmeldetag: 23.10.1987
(51) Int. Cl.: H01H 11/00

(54) **Elektrisches Gerät, insbesondere elektrischer Schalter für Kraftfahrzeuge**
Electrical device particularly electrical switch for vehicles
Appareil électrique, en particulier commutateur électriques pour véhicules

(30) Priorität: 26.05.1987 DE 3717743
(43) Veröffentlichungstag der Anmeldung: 30.11.1988
(73) Patentinhaber: SWF Auto-Electric GmbH, D-74321 Bietigheim-Bissingen (DE)
(72) Erfinder: Bühler, Roland, D-7100 Heilbronn (DE); Erdelitsch, Herbert, D-7120 Bietigheim-Bissingen (DE); Hecht, Walter, D-7120 Bietigheim-Bissingen (DE)

(56) Entgegenhaltungen:
- EP-A- 0 200 175
- DE-A- 2 505 120
- DE-A- 2 533 802
- DE-A- 3 219 579
- DE-A- 3 327 199
- FR-A- 2 532 256

## Beschreibung

Die Erfindung betrifft zwei unterschiedliche Stanzplatinen, die für zwei unterschiedliche elektrische Geräte verwendet werden und die die Merkmale aus dem Oberbegriff des Anspruchs 1 aufweisen. Die Erfindung betrifft außerdem zwei unterschiedliche elektrische Geräte, die insbesondere als elektrische Schalter für Kraftfahrzeuge verwendet werden und die Merkmale aus dem Oberbegriff des Anspruchs 6 aufweisen.

Ein elektrischer Schalter mit einer Stanzplatine ist in Form eines Lenkstockschalters aus der DE-OS 35 15 911 bekannt. Eine Grundplatte dieses Schalters ist als Spritzgußteil hergestellt. In den Kunststoff ist eine Stanzplatine mit einzelnen metallischen Leiterbahnen eingespritzt. An einseitig von Kunststoff freigesparten Aussparungen bilden die Leiterbahnen direkt die Festkontakte des elektrischen Schalters. Auch die als Flachstecker ausgebildeten Außenanschlüsse des elektrischen Schalters werden durch Abschnitte der einzelnen Leiterbahnen gebildet.

Bei der Herstellung des elektrischen Schalters werden die einzelnen, die Stanzplatine bildenden Leiterbahnen zunächst aus einem Blech ausgestanzt. Um die weitere Handhabbarkeit zu erleichtern, sind die Leiterbahnen noch durch schmale Brücken miteinander verbunden, so daß die Leiterbahnen in einem als Stanzplatine bezeichnetem Bauteil zusammengefaßt bleiben. Die Stanzplatine wird in das Spritzgießwerkzeug eingelegt und darin in den Kunststoff der Schaltergrundplatte eingegossen, so daß weitere Arbeitsschritte zur Befestigung der Stanzplatine am Grundteil nicht notwendig sind. Im Bereich der die Leiterbahnen verbindenden Brücken ist der Kunsttoff zu beiden Seiten der Stanzplatine ausgespart, so daß nach dem Spritzgießen die Brücken leicht durchtrennt werden können.

Manchmal ist es notwendig, verschiedene Ausführungen eines vom grundsätzlichen Aufbau her gleichen elektrischen Geräts, z. B. eines elektrischen Schalters, herzustellen. So ist es z. B. denkbar, daß für ein bestimmtes Kraftfahrzeug eine Ausführung gewünscht wird, bei der die Lastströme eines oder mehrerer über den elektrischen Schalter steuerbaren Verbraucher(s) über die Leiterbahnen der Stanzplatine fließen. Bei einem anderen mit mehr Elektronik ausgestatteten Fahrzeug dagegen sollen nur Steuerströme über den elektrischen Schalter fließen. Derartige unterschiedliche Funktionen verschiedener Ausführungen desselben Schaltertyps können auch unterschiedlich gestaltete Stanzplatinen bedingen.

Der Erfindung liegt die Aufgabe zugrunde, zwei unterschiedliche Stanzplatinen bzw. zwei unterschiedliche, insbesondere als elektrische Schalter verwendete elektrische Geräte, die die Merkmale aus dem Oberbegriff des Anspruchs 1 bzw. des Anspruchs 6 aufweisen, so weiterzuentwickeln, daß die unterschiedlichen elektrischen Geräte auf kostengünstige Weise hergestellt werden können.

Diese Aufgabe wird erfindungsgemäß zunächst durch zwei unterschiedliche Stanzplatinen gelöst, die außer den Merkmalen aus dem Oberbegriff zusätzlich die Merkmale aus dem kennzeichnenden Teil des Anspruchs 1 aufweisen. Die Aufgabe wird erfindungsgemäß aber auch durch zwei unterschiedliche elektrische Geräte gelöst, die außer den Merkmalen aus dem Oberbegriff zusätzlich die Merkmale aus dem kennzeichnenden Teil des Anspruchs 6 aufweisen.

Danach sind also bei zwei erfindungsgemäßen unterschiedlichen Stanzplatinen bzw. bei zwei erfindungsgemäßen unterschiedlichen elektrischen Geräten wenigstens ein Teil der nach dem Ausstanzen noch vorhandenen Brücken zwischen den einzelnen Leiterbahnen der einen Stanzplatine bezüglich der Endabschnitte bzw. des Kunststoffbauteils an denselben Stellen vorgesehen, an denen auch die andere Stanzplatine Brücken hat. Diese Anordnung der Brücken an gleichen Stellen der verschiedenen Stanzplatinen eröffnet die Möglichkeit, das gleiche Spritzwerkzeug für die Herstellung des Kunststoffbauteils und das gleiche Trennwerkzeug zum Durchtrennen der die einzelnen Leiterbahnen verbindenden Brücken zu benutzen. Die das Durchtrennen der Brücken erleichternden Aussparungen im Kunststoff befinden sich, sofern solche vorhanden sind, dann unabhängig von der konkreten Ausgestaltung der Stanzplatinen jeweils im Bereich der Brücken.

Natürlich ist eine erfindungsgemäße Gestaltung zweier Stanzplatinen bzw. zweier elektrischer Geräte auch dann von Vorteil, wenn die Stanzplatinen nicht direkt in das Kunststoffteil eingespritzt, sondern an dem schon fertigen Kunststoffteil auf irgendeine Art befestigt werden. Denn dann kann zumindest noch zum Durchtrennen der Brücken dasselbe Werkzeug verwendet werden.

Vorteilhafte Ausgestaltungen zweier erfindungsgemäßer unterschiedlicher Stanzplatinen kann man den Unteransprüchen 2 bis 5 entnehmen.

Zweckmäßigerweise wird man versuchen, möglichst viele Brücken einer Stanzplatine an denselben Stellen vorzusehen, wie bei der anderen Stanzplatine. Haben die beiden Stanzplatinen unterschiedlich viele Brücken so befinden sich vorteilhafterweise alle Brücken der Stanzplatine mit einer geringeren Anzahl von Brücken an solchen Stellen, an denen auch die andere Stanzplatine Brücken aufweist. Haben beide Stanzplatinen gleich viele Brücken, so befinden sich diese vorteilhafterweise bei der einen Stanzplatine alle an denselben Stellen wie bei der anderen Stanzplatine.

Besitzen die Stanzplatinen innerhalb einer oder mehrerer Leiterbahnen einen oder mehrere Durchbrüche zum Halten an einem Werkzeug, so befindet sich zweckmäßigerweise gemäß Anspruch 5 wenigstens ein Durchbruch bezüglich der Endabschnitte an derselben Stelle wie bei der anderen Stanzplatine.

Vorteilhafte Ausgestaltungen zweier erfindungsgemäßer unterschiedlicher elekektrischer Geräte kann man den Unteransprüchen 7 bis 11 entnehmen.

Zwei unterschiedliche elektrische Schalter bzw. zwei unterschiedliche Stanzplatinen, an denen die Erfindung verwirklicht ist, sind in den Zeichnungen dargestellt. Anhand der Figuren dieser Zeichnungen wird die Erfindung nun näher erläutert.

Es zeigen:
- Figur 1: einen Lenkstockschalter mit aus einer Grundplatte und einem Deckel zusammengesetzten Gehäuse und einem Schalthebel,
- Figur 2: einen Schnitt durch die Grundplatte des Schalters entlang der Linie II-II aus Figur 1,
- Figur 3: einen Schnitt entlang der Linie III-III aus Figur 2,
- Figur 4: die Stanzplatine der Ausführung nach den Figuren 2 und 3 und
- Figur 5: eine von der Stanzplatine nach Figur 4 verschiedene Stanzplatine, bei der sich die die Leiterbahnen noch verbindenden Brücken bis auf eine an denselben Stellen wie bei der Stanzplatine nach Figur 4 befinden.

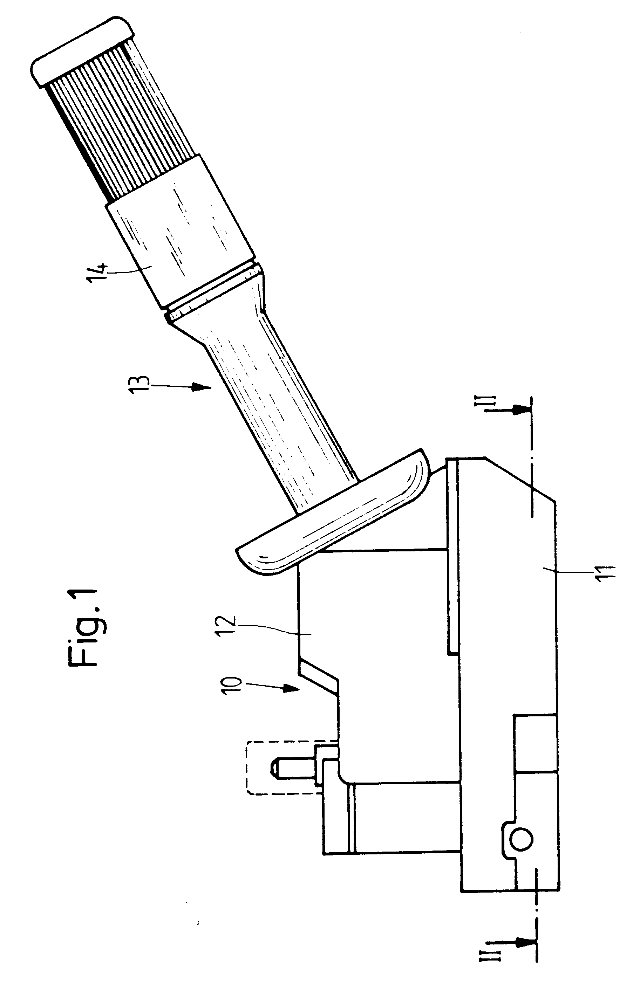

Der in Figur 1 dargestellte elektrische Schalter ist als Lenkstockschalter für ein Kraftfahrzeug konstruiert und dient dazu, Wisch- und Waschanlagen für die Front- und Heckscheibe eines Kraftfahrzeuges zu steuern. Das Gehäuse 10 des Schalters setzt sich im wesentlichen aus einer Grundplatte 11 und einem Deckel 12 zusammen. Im Gehäuse 10 ist ein Schalthebel 13 so gelagert, daß er um eine senkrecht auf der Grundplatte 11 stehende Achse horizontal und um eine durch diese Achse gehende und senkrecht darauf stehende Achse vertikal verschwenkt werden kann. Außerdem kann der Griff 14 des Schalthebels 13 zusammen mit einer sich im Innern des Schalthebels vom Griff bis in das Schaltergehäuse 10 erstreckenden Schaltstange um die Längsachse des Schalthebels 13 gedreht werden.

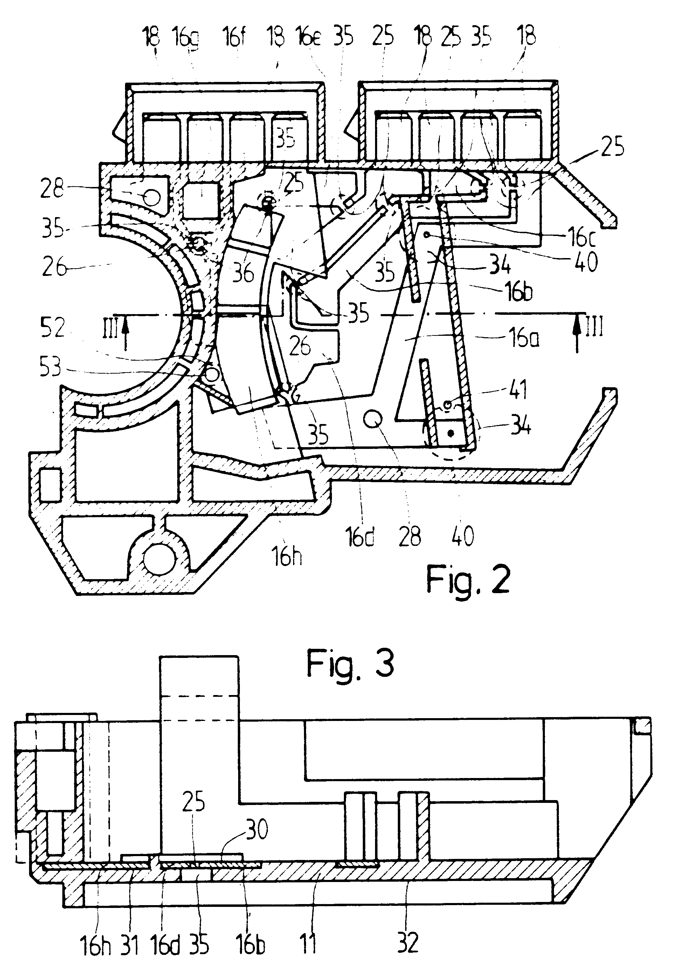

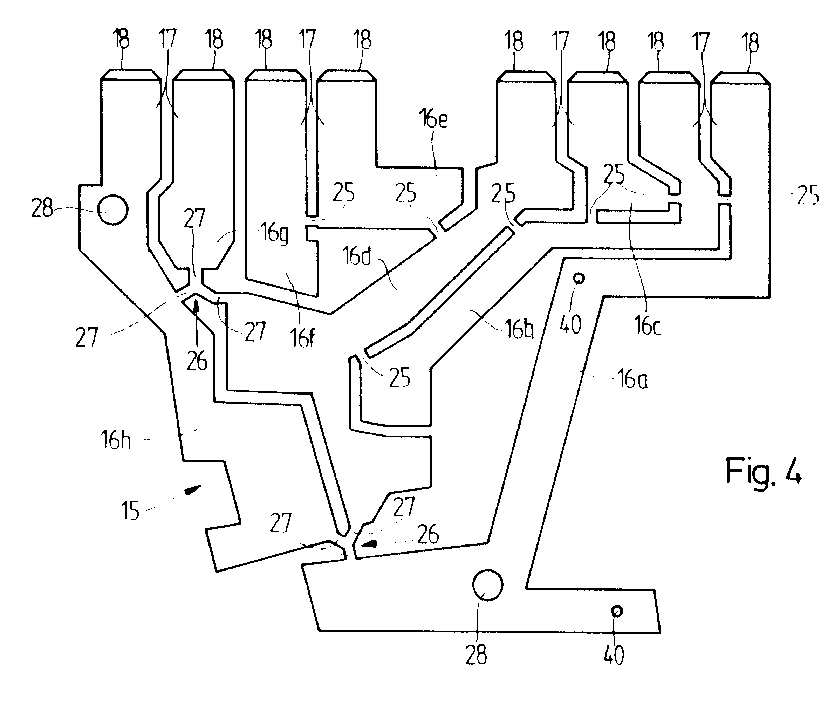

Die Grundplatte 11 des Schalters ist aus Kunststoff im Spritzgießverfahren hergestellt. Während des Spritzvorgangs wird in sie eine Stanzplatine 15 aus einem Kupferblech eingebettet, die naher in Figur 4 dargestellt, jedoch auch aus den Schnitten gemäß den Figuren 2 und 3 ersichtlich ist. Die Stanzplatine 15 setzt sich aus insgesamt acht jeweils anders gestalteten Leiterbahnen 16a bis 16h zusammen, die in zueinander parallelen als Flachstecker 17 ausgebildeten Endabschnitten auslaufen, die in zwei Gruppen zu je vier Flachsteckern zusammengefaßt sind und deren freie Stirnflächen 18 auf einer Linie liegen.

Damit die einzelnen Leiterbahnen 16a bis 16h zunächst noch als einstückige Stanzplatine gehandhabt werden können, sind sie durch schmale Brücken 25 bzw. 26 noch miteinander verbunden. Die Brücken 25 erstrecken sich jeweils zwischen zwei Leiterbahnen. Sie gehen senkrecht von der Seitenkante der einen Leiterbahn ab und münden senkrecht in die benachbarte Seitenkante der anderen Leiterbahn. Die Brücken 26 dagegen setzen sich aus drei sternförmig angeordneten Teilbrücken 27 zusammen und verbinden drei Leiterbahnen 16 miteinander.

Zum Einbetten der Stanzplatine 15 in die Grundplatte 11 wird die Stanzplatine so, wie sie in Figur 4 dargestellt ist, also mit noch über die Brücken 25 und 26 verbundenen Leiterbahnen 16, in das Spritzgießwerkzeug eingelegt. Um sie darin halten zu können, ist aus den Leiterbahnen 16a und 16h jeweils ein kreisrundes Loch 28 ausgestanzt, in das das Werkzeug mit einem Stift eingreift.

Die Leiterbahnen 16 dienen in bestimmten Abschnitten als Festkontakte des elektrischen Schalters, auf denen Schiebekontakte entlang bewegt werden können. Die Leiterbahnen 16 liegen deshalb, wie insbesondere aus den Figuren 2 und 3 ersichtlich ist, mit weiten Bereichen ihrer einen Flachseite 30 auf gleichem Niveau wie der sie umgebende Kunststoff. Auf der Flachseite 30 können sie deshalb ohne weiteres im Spritzwerkzeug abgestützt werden. Die andere Flachseite 31 der Leiterbahnen 16 hat, wie die Figur 3 deutlich zeigt, einen Abstand von der Unterseite 32 der Grundplatte 11. Auf der Seite 31 ist die Stanzplatine 15 während des Spritzvorgangs deshalb nur an einzelnen Dornen des Spritzgießwerkzeugs abgestützt, so daß die fertigte Grundplatte entsprechend dem zylindrischen Querschnitt der Dorne mehrere kreisrunde Aussparungen 34 bzw. 35 besitzt, die sich von der Unterseite 32 der Grundplatte 11 bis zur Flachseite 31 der Stanzplatine 15 erstrecken. Die Aussparungen 34 und 35 sind in Figur 2 durch strichlinierte Kreise dargestellt.

In Figur 2 ist die Grundplatte 11 in einem Fertigungsstadium gezeigt, in dem die Brücken 25 und 26 zwischen den Leiterbahnen 16 der Stanzplatine 15 noch nicht durchtrennt sind. Wie man sieht, befinden sich die Aussparungen 35 unterhalb der die Leiterbahnen 16 der Stanzplatine 15 verbindenden Brücken 25 und 26. Dadurch wird das Ausstanzen der Brücken erleichtert. Ist die Stanzplatine im Bereich einer Brücke 25 oder 26 auch auf ihrer Flachseite 30 von Kunststoff überdeckt, so hat die Grundplatte 11 auch auf dieser Seite über der Brücke eine kreisrunde Aussparung, die mit der Bezugszahl 36 versehen ist. Die Aussparungen 36 tragen ebenfalls dazu bei, daß die entsprechenden Brücken 25 bzw. 26 leicht ausgestanzt werden können.

Die Aussparungen 34 sind wesentlich größer als die Aussparungen 35 und umgeben konzentrisch jeweils eine kleine Bohrung 40 in einer der Leiterbahnen 16. Durch die Bohrungen 40 und die Bohrung 41 in der Grundplatte 11 werden drei Füßchen eines nicht näher dargestellten Schiebepotentiometers gesteckt. Die beiden Füßchen in den Bohrungen 40 werden mit der Leiterbahn 16a verlötet. Die Größe der Aussparungen 34 erleichtert den Lötvorgang.

Die in den Figuren 2 und 3 als in die Grundplatte 11 eingebettet und in Figur 4 gesondert dargestellte Stanzplatine 15 besitzt also an bestimmten Stellen Brücken 25, 26, die die verschiedenen Leiterbahnen 16 zunächst zu einem einzigen Teil verbinden, an denen die Stanzplatine 15 im Spritzwerkzeug abgestützt ist und die erst nach dem Spritzvorgang mit Hilfe eines Stanzwerkzeugs weggestanzt werden.

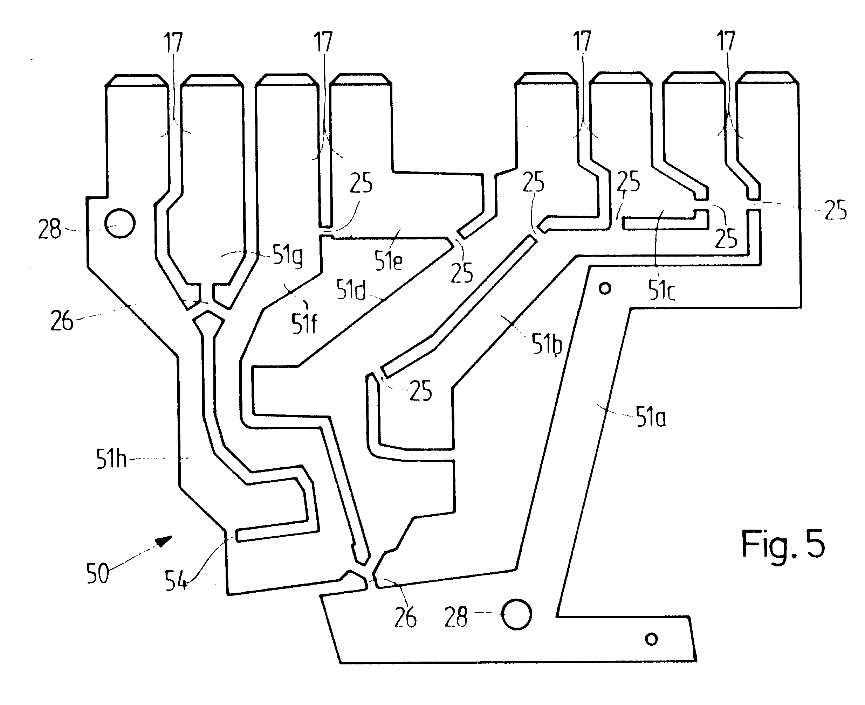

In Figur 5 ist eine Stanzplatine 50 mit Leiterbahnen 51a bis 51h dargestellt, die wiederum in zwei Gruppen von parallel zueinanderliegenden Flachsteckern 17 enden. Die Stanzplatine 50 hat zwar eine gewisse Ähnlichkeit mit der Stanzplatine 15, unterscheidet sich jedoch in der Form einzelner Leiterbahnen von dieser und muß deshalb als von der Stanzplatine 15 verschiedene Stanzplatine betrachtet werden. Im wesentlichen gleiche Form haben die Leiterbahnen 16a und 51a, 16b und 51b, 16c und 51c, 16e und 51e sowie 16g und 51g. Zum Teil recht große Unterschiede bestehen zwischen den Leiterbahnen 16d und 51d, 16f und 51f sowie 16h und 51h.

Die Stanzplatine 50 ist dafür vorgesehen, wie die Stanzplatine 15 in die in den Figuren 2 und 3 dargestellte Grundplatte 11 eingespritzt zu werden, um durch die Verwendung von gleichen Grundplatten mit unterschiedlichen Stanzplatinen verschiedene, im grundsätzlichen Aufbau und in der äußeren Form jedoch gleiche Ausführungen eines elektrischen Schaltertyps herstellen zu können. Damit nun zum Einbetten der Stanzplatine 15 oder der Stanzplatine 50 in die gleiche Grundplatte 11 das gleiche Spritzgießwerkzeug und zum Wegstanzen der Brücken 25 und 26 das gleiche Stanzwerkzeug verwendet werden können, besitzt die Stanzplatine 50, obwohl sie sich von der Stanzplatine 15 unterscheidet, an denselben Stellen wie die Stanzplatine 15 Brücken 25 und 26. An denselben Stellen heißt dabei, daß nach dem Spritzvorgang Brücken 25 und 26 der Stanzplatine 50 an denselben Stellen zu finden sind, wie wenn die Stanzplatine 15 eingespritzt worden wäre.

In Figur 2 erkennt man außer den Aussparungen 35 und 36 an den Stellen der Stanzplatine 15, wo diese Brücken 25 und 26 aufweist, eine durch einen gestrichelten Kreis angedeutete weitere Aussparung 52, die in ihrer Größe und ihrer Lage an der Unterseite der Stanzplatine 15 einer Aussparung 35 entspricht, und eine Aussparung 53, die in ihrer Größe und ihrer Lage auf der Oberseite der Stanzplatine 15 einer Aussparung 36 entspricht. Bei der mit der Stanzplatine 15 ausgestatteten Grundplatte 11 aus Figur 2 ist innerhalb der Aussparungen 52 und 53 keine Brücke der Stanzplatine zu erkennen. Nun besitzt jedoch die Stanzplatine 50 aus Figur 5 gegenüber der Stanzplatine 15 aus Figur 4 eine zusätzliche, die Leiterbahnen 51f und 51h verbindende Brücke 54. Diese Brücke liegt, wenn die Stanzplatine 50 in die Grundplatte 11 eingespritzt wird, innerhalb der Aussparungen 52 und 53. Das Spritzwerkzeug der Grundplatte 11 sowie das Stanzwerkzeug, mit dem die Brücken der eingebetteten Stanzplatine abgestanzt werden sollen, sind also auf die Stanzplatine mit den meisten Brücken ausgelegt. Nach dem Ausstanzen der Brücken können sich also, wenn eine Stanzplatine eingebettet worden ist, bei der die Anzahl der Brücken nicht der Höchstzahl entspricht, auch dort Durchbrüche in der Grundplatte 11 befinden, wo keine Brücke zwischen den einzelnen Leiterbahnen einer Stanzplatine vorhanden war.

Natürlich befinden sich auch die beiden Haltelöcher 28 der Stanzplatine 50 an denselben Stellen wie bei der Stanzplatine 15.

## Patentansprüche

1. Zwei unterschiedliche Stanzplatinen (15, 50) für zwei unterschiedliche elektrische Geräte, die jeweils mehrere einzelne Leiterbahnen (16a - 16h; 51a - 51h) und mehrere, die einzelnen Leiterbahnen (16a - 16h; 51a - 51h) miteinander verbindende Brücken (25, 26, 54) sowie Endabschnitte (17) aufweisen, die als elektrische Steckkontakte dienen oder an denen unmittelbar elektrische Steckkontakte befestigt werden können, dadurch gekennzeichnet, daß sich wenigstens ein Teil der Brücken (25, 26) der einen Stanzplatine (15) bezüglich der Endabschnitte (17) an solchen Stellen befindet, an denen auch die andere Stanzplatine (50) Brücken hat.

2. Stanzplatinen (15, 50) nach Anspruch 1, dadurch gekennzeichnet, daß sie im Bereich der Endabschnitte (17) gleich ausgebildet sind.

3. Stanzplatinen (15, 50) nach Anspruch 1 oder 2, dadurch gekennzeichnet, daß sich alle Brücken (25, 26) der einen Stanzplatine (15) bezüglich der Endabschnitte (17) an solchen Stellen befinden, an denen auch die andere Stanzplatine (50) Brücken (25, 26) hat.

4. Stanzplatinen (15, 50) nach Anspruch 1, 2 oder 3, dadurch gekennzeichnet, daß die eine Stanzplatine die gleiche Anzahl von Brücken und alle Brücken an denselben Stellen aufweist wie die andere Stanzplatine.

5. Stanzplatinen (15, 50) nach einem der Ansprüche 1 bis 4, dadurch gekennzeichnet, daß jede von ihnen innerhalb einer oder mehrerer Leiterbahnen (16a, 16h; 51a, 51h) einen oder mehrere Durchbrüche (28) zum Halten an einem Werkzeug aufweist und daß sich wenigstens ein Durchbruch (28) der einen Stanzplatine (15, 50) bezüglich der Endabschnitte (17) an derselben Stelle wie bei der anderen Stanzplatine (50, 15) befindet.

6. Zwei unterschiedliche elektrische Geräte, insbesondere zwei unterschiedliche elektrische Schalter für Kraftfahrzeuge, die ein gleiches, aus Kunststoff aufgebautes Bauteil (11) aufweisen, an dem jeweils eine Stanzplatine (15, 50) befestigt ist, die einzelne, nach dem Ausstanzen noch durch schmale Brücken (25, 26, 54) miteinander verbundene Leiterbahnen (16a - 16h; 51a - 51h) besitzt, dadurch gekennzeichnet, daß die beiden Stanzplatinen (15, 50) unterschiedlich gestaltet sind und daß wenigstens ein Teil der nach dem Ausstanzen noch vorhandenen schmalen Brücken (25, 26) der einen Stanzplatine (15) bezüglich des Kunststoffteils (11) an solchen Stellen vorgesehen ist, an denen auch die andere Stanzplatine (50) Brücken (25, 26) hat.

7. Elektrische Geräte nach Anspruch 6, dadurch gekennzeichnet, daß die Stanzplatinen (15, 50) in das jeweilige Kunststoffteil (11) eingespritzt sind.

8. Elektrische Geräte nach Anspruch 6 oder 7, dadurch gekennzeichnet, daß die eine Stanzplatine (15, 50) innerhalb einer oder mehrerer Leiterbahnen (16a, 16h; 51a, 51h) einen oder mehrere Durchbrüche (28) zum Halten an einem Werkzeug aufweist und daß sich wenigstens ein Durchbruch (28) bezüglich des Kunststoffteils (11) an derselben Stelle wie bei der anderen Stanzplatine (50, 15) befindet.

9. Elektrische Geräte nach einem der Ansprüche 6 bis 8, dadurch gekennzeichnet, daß die beiden Kunststoffteile (11) auf der einen Seite der Stanzplatine (15, 50) im Bereich von Brücken (25, 26) jeweils eine bis zur Stanzplatine (15, 50) reichende, vorzugsweise kreisrunde Aussparung (35) besitzen und daß beim einen Kunststoffteil (11) zumindest eine zusätzliche Aussparung (52, 63) an einer Stelle vorgesehen ist, an der an der anderen Stanzplatine (50), jedoch nicht an der eingebetteten Stanzplatine (15), eine Brücke vorgesehen ist.

10. Elektrische Geräte nach Anspruch 9, dadurch gekennzeichnet, daß nach dem Spritzen der Kunststoffteile (11) auch auf der gegenüberliegenden Seite der jeweiligen Stanzplatine (15, 50) im Bereich mindestens einer Brücke (25, 26) eine bis zur Stanzplatine (15, 50) reichende und auf den Bereich der Brücke (25, 26) beschränkte, vorzugsweise auf den Querschnitt eines Stanzstempels abgestimmte Aussparung (36) im Kunststoffteil (11) vorhanden ist und daß beim einen Kunststoffteil zumindest eine zusätzliche Aussparung (52, 53) an einer Stelle vorgesehen ist, an der an der anderen Stanzplatine (50), jedoch nicht an der eingebetteten Stanzplatine (15), eine Brücke (54) vorgesehen ist.

11. Elektrische Geräte nach einem der Ansprüche 6 bis 10, dadurch gekennzeichnet, daß die beiden Stanzplatinen (15, 50) im Bereich der Endabschnitte (17), die als elektrische Steckkontakte dienen oder an denen unmittelbar elektrische Steckkontakte befestigt werden können, gleich ausgebildet sind.

## Claims

1. Two different boards (15, 50) for two different electric devices of which each has several individual metal conductors (16a - 16h; 51a - 51h) and several bridges (25, 26, 54) connecting the individual metal conductors (16a - 16h; 51a - 51h) as well as end portions (17) serving as electric plug contacts or on which electric plug contacts can be directly fixed, characterised in that at least part of the bridges (25, 26) of one board (15) relative to the end portions are positioned in such places in which also the other board (50) has bridges.

2. Boards (15, 50) according to claim 1, characterised in that in the area of the end portions (17) they are developed in the same way.

3. Boards (15, 50) according to claim 1 or 2, characterised in that all bridges (25, 26) of one board (15) relative to the end portions (17) are positioned in such places in which also the other board (50) has bridges (25, 26).

4. Boards (15, 50) according to claims 1, 2 or 3, characterised in that one board has the same number of bridges in the same places as the other board.

5. Boards (15, 50) according to one of the claims 1 to 4, characterised in that within one or more metal conductors (16a, 16h; 51a, 51h) each of them comprises one or more apertures (28) for being held on a tool and that at least one aperture (28) of one board (15, 50) relative to the end portions (17) is located in the same place as in the other board (50, 15).

6. Two different electric devices, in particular two different electric switches for motor vehicles, which comprise an equal component made of plastic material, on which component is fastened a board (15, 50) each having individual metal conductors (16a - 16h; 51a - 51h) connected with one another by narrow bridges (25, 26, 54), characterised in that the two boards are differently developed and that at least part of the narrow bridges (25, 26) still available after punching with respect to the plastic part (11) is provided in such places in which also the other board (50) has bridges (25, 26).

7. Electric devices according to claim 6, characterised in that the boards (15, 50) are injection-moulded into the respective plastic part (11).

8. Electric devices according to claim 6 or 7, characterised in that within one or more metal conductors (16a, 16h; 51a, 51h) one board comprises one or more apertures (28) for being held on a tool and that at least one aperture (28) with respect to the plastic part (11) is positioned in the same place as in the other board (50, 15).

9. Electric devices according to one of claims 6 to 8, characterised in that on one side of the board (15, 50) in the area of bridges (25, 26) the two plastic parts (11) have a preferably circular recess (35) reaching as far as to the board (15, 50) and that in the plastic part (11) at least one additional recess (52, 63) is provided in a place, in which on the other board (50), but not on the embedded one, a bridge is provided.

10. Electric devices according to claim 9, characterised in that after injection-moulding of the plastic parts (11) a recess (36) in the plastic part (11) is provided in the area of at least one bridge (25, 26) also at the opposite side of the respective board (15, 50) reaching as far as to the board (15, 50) and restricted to the area of the bridge (26, 26), which recess in the plastic part (11) is preferably adapted to the cross-section of a stamping punch and that in one plastic part at least one additional recess (52, 53) is provided in a place, in which on the other board, but not on the embedded board (15) a bridge is provided.

11. Electric devices according to one of claims 6 to 10, characterised in that the two boards (15, 50) are equally shaped in the area of the end portions (17) serving as electric plug contacts or on which electric plug contacts can be directly fixed.

## Revendications

1. Deux platines découpées différentes (15,50) pour deux appareils électriques différents qui présentent respectivement plusieurs bandes conductrices séparées (16a, 16b; 51a, 51b), plusieurs bandes conductrices séparées (16a, 16b; 51a, 51b) étant reliées entre elles par des ponts (25,26,54) ainsi que des sections terminales (17) qui servent de contacts électriques à fiche ou auxquelles des contacts à fiche peuvent être directement fixés, caractérisées en ce qu'au moins une partie des ponts (25,26) de l'une des platines découpées (15) relativement aux sections terminales (17) se trouvent à des emplacements auxquels l'autre platine découpée (50) possède également des ponts.

2. Platines découpées (15,50) suivant la revendication 1, caractérisées en ce qu'elles sont formées de manière identique dans la partie des sections terminales (17).

3. Platines découpées (15,50) suivant la revendication 1 ou 2, caractérisées en ce que tous les ponts (25,26) de l'une des platines découpées (15) relativement aux sections terminales (17) se trouvent à des emplacements auxquels l'autre platine découpée (50) possède également des ponts (25,26).

4. Platines découpées (15,50) suivant la revendication 1, 2 ou 3, caractérisées en ce que l'une des platines découpées présente le même nombre de ponts et tous les ponts aux mêmes emplacements que l'autre platine découpée.

5. Platines découpées (15,50) suivant l'une des revendications 1 à 4, caractérisées en ce que chacune d'elles comporte une ou plusieurs perforations (28) à l'intérieur d'une ou plusieurs bandes conductrices (16a, 16b; 51a, 51b) pour la maintenir sur un outil et qu'il se trouve au moins une perforation (28) de l'une des platines découpées (15,50) relativement aux sections terminales (17) au même emplacement que dans l'autre platine découpée (50,15).

6. Deux appareils électriques différents, en particulier deux commutateurs électriques différents pour véhicules automobiles qui présentant une pièce de construction identique (11) réalisée en matière plastique, à laquelle est fixée respectivement une platine découpée (15,50) qui possède des bandes conductrices (16a, 16b; 51a, 51b) séparées, reliées entre elles après la découpe par des ponts étroits (25,26,54), caractérisés en ce que les deux platines découpées (15,50) sont formées différemment et qu'au moins une partie des ponts étroits (25,26) de l'une des platines découpées (15) relativement à la pièce en matière plastique (11) existants après la découpe sont prévus à des emplacements auxquels l'autre platine découpée (50) possède également des ponts (25,26).

7. Appareils électriques suivant la revendication 6, caractérisés en ce que les platines découpées (15,50) sont injectées dans la pièce en matière plastique (11).

8. Appareils électriques suivant la revendication 6 ou 7, caractérisés en ce que les platines découpées (15,50) comportent une ou plusieurs perforations (28) à l'intérieur d'une ou plusieurs bandes conductrices (16a, 16b; 51a, 51b) pour le maintien sur un outil et qu'il se trouve au moins une perforation (28) relativement à la pièce en matière plastique (11) au même emplacement que dans l'autre platine découpée (50, 15).

9. Appareils électriques suivant l'une des revendications 6 à 8, caractérisés en ce que les deux pièces en matière plastique (11) possèdent sur l'une des faces de la platine découpée (15,50) à proximité des ponts (25,26) respectivement un évidement (35) de préférence circulaire atteignant la platine découpée (15,50) et que sur une pièce en matière plastique (11) au moins un évidement supplémentaire (52,63) est prévu à un emplacement, auquel un pont est prévu sur l'autre platine découpée (50) mais pas sur la platine découpée (15) enrobée.

10. Appareils électriques suivant la revendication 9, caractérisés en ce qu'un évidement (36) ajusté de préférence sur la coupe transversale d'un poinçon de découpe existe également après l'injection de la pièce en matière plastique (11), sur le côté faisant face de la platine découpée (15,50) respective, à proximité d'au moins un pont (25,26) atteignant la platine découpée (15,50) et limité à la partie des ponts (25,26) et que dans une pièce en matière plastique, au moins un évidement supplémentaire (52,53) est prévu à un emplacement auquel un pont (54) est prévu sur l'autre platine découpée (50) mais pas sur la platine découpée (15) enrobée.

11. Appareils électriques suivant l'une des revendications 6 à 10, caractérisés en ce que les deux platines découpées (15,50), dans la partie des sections terminales (17) qui servent de contact ou auxquelles des contacts à fiche peuvent être directement fixés, sont formées de manière identique.
